# DEMANDE DE BREVET EUROPEEN

(11) **EP 2 843 563 A1**
(43) Date de publication de la demande: **04.03.2015**
(21) Numéro de dépôt: 14173978.9
(22) Date de dépôt: 25.06.2014
(51) Int. Cl.: G06F 13/42, H05K 7/14

(54) **Architecture d'interconnexion de lames pour un équipement de réseau du type châssis modulaire, notamment de type ATCA**

(30) Priorité: 28.06.2013 FR 1356329
(71) Demandeur: Online SAS, 75008 Paris (FR)
(72) Inventeur: de Turckheim, Grégoire, 75017 PARIS (FR)
(74) Mandataire: Dupuis-Latour, Dominique

(57) **Abrégé**

Chaque lame (10) comprend une interface de couplage dotée d'une pluralité de ports de connexion à une liaison réseau, et une carte de fond de panier (12) porte un routage de liaisons réseau pour coupler entre elles les N lames (L₁, L₂... L_{N}). Celles-ci sont ordonnées selon une séquence logique de chainage prédéfinie et sont couplées séquentiellement entre elles, chaque lame étant couplée par un premier port à la lame qui la précède et par un second port à la lame qui la suit, via une liaison réseau unique (22, 24) configurée sur la carte de fond de panier. La connectique matérielle de la carte de fond de panier est celle d'une architecture *dual star* non modifiée, avec sur chaque lame lesdits deux ports de connexion pour deux liaisons réseau. Chacune des lames comporte des moyens de transfert en cascade des données destinées à une autre des N lames du premier port vers le second port, ou *vice versa.* Le châssis est dépourvu de lames dédiées à l'interconnexion redondante des liaisons entre les autres lames du châssis.

## Description

L'invention concerne les équipements de réseau modulaires, en particulier les équipements tels que ceux utilisés dans les installations à grande échelle telles que grappes de serveurs, réseaux de télécommunications, routeurs... mises en oeuvre par les hébergeurs web, les fournisseurs d'accès Internet, les centres de stockage et de traitement de données de type *datacenter,* etc.

Ces équipements modulaires se présentent sous la forme de châssis installés dans des baies, chaque châssis comportant une pluralité de modules ou "lames" amovibles et une carte de fond de panier ou *backplane* recevant ces lames dans autant d'emplacements ou *slots.*

Chaque lame comporte sur une même carte de circuit un ou plusieurs serveurs (notamment pour les architectures de type "microserveur" regroupant un nombre important de serveurs sur une même lame), le tout sur une faible épaisseur physique, ce qui permet de juxtaposer une pluralité de lames identiques côte-à-côte dans un même châssis, typiquement 14 ou 16 lames par châssis. Les lames peuvent être retirées et échangées indépendamment les unes des autres, et il est en outre possible d'héberger dans un même châssis des lames offrant des fonctionnalités différentes. Le châssis comprend par ailleurs des moyens d'alimentation des lames, de refroidissement et de ventilation, et assure des fonctions communes aux lames de mise en réseau et d'interconnexion par un routage configuré sur le fond de panier.

L'invention vise plus particulièrement les châssis de type ATCA *(Advanced Telecommunications Computing Architecture),* qui est une spécification du *PCI Industrial Computers Manufacturers Group* définissant un standard matériel de châssis et de lames ainsi que la manière d'interfacer ces éléments, notamment pour permettre aux lames de communiquer entre elles via des liaisons série haute vitesse dans une architecture commutée, dont la topologie est définie par la carte de fond de panier. Plus précisément, les spécifications ATCA définissent deux types de lames, à savoir :
- les lames dites "productives", qui offrent la fonctionnalité externe attendue : par exemple recueil du trafic de télécommunications, hébergement d'un serveur, etc. ; et
- les lames dites "réseau", qui sont des lames dédiées à des fonctions internes au châssis, consistant notamment à assurer la mise en réseau des autres lames (les lames productives) du même châssis ainsi que le *monitoring* ou supervision de ce réseau : détection des anomalies de transmission, recueil des informations des capteurs de chaque lame (notamment les capteurs de température), mesure de la charge de trafic du réseau, etc.

Les spécifications ATCA définissent par ailleurs deux topologies possibles de mise en réseau des N lames d'un même châssis, correspondant à deux types de fond de panier avec des routages différents entre lames :
- la première architecture, la plus utilisée, est dite *dual star,* et elle prévoit de disposer sur le châssis deux lames réseau et N-2 lames productives, chacune des lames réseau étant reliée à chacune des lames productives selon une topologie en étoile de type "1-vers-N". Le doublement des lames réseau répond à un impératif de redondance, le trafic réseau entre les lames productives devant pouvoir continuer même en cas de défaillance de l'une des lames réseau.
   L'avantage de cette topologie est de n'occuper sur chaque lame productive que deux ports de connexion pour l'interconnexion avec les autres lames, les autres ports restant disponibles pour des liaisons externes : raccordement d'un abonné dans le cas d'un réseau de télécommunications, liaison réseau à un serveur de la lame dans le cas d'un hébergement de serveur, etc.
   Son inconvénient est de nécessiter pour chaque châssis deux lames dédiées au réseau, donc de devoir gérer deux types de lames différentes (lames réseau/lames productives) et de ne laisser à disposition que N-2 lames productives dans un châssis comportant N emplacements (typiquement, 12 lames productives pour un châssis de 14 *slots,* ou 14 lames productives pour un châssis de 16 *slots*).
- la seconde architecture est dite *full mesh.* Elle prévoit de n'utiliser que des lames productives, et de connecter chacune des N lames du châssis à chacune des N-1 autres lames de ce même châssis selon une topologie maillée de type "N-vers-N".
   L'avantage de cette topologie est de ne nécessiter aucune lame réseau, mais son inconvénient est d'occuper un nombre élevé de ports réseau sur chaque lame (jusqu'à 15 ports réseau dédiés à l'interconnexion) et d'imposer en outre une topologie de type "N-vers-N" très complexe à gérer.

Diverses propositions ont été formulées pour améliorer les performances de ces architectures.

Ainsi, le US 2004/0042448 A1 a pour objet l'implémentation d'une topologie de type *mesh* (maillage) où chacune des N lames du châssis est reliée à chacune des N-1 autres lames de ce même châssis selon une topologie de type "N-vers-N". Cette topologie est mise en oeuvre par un anneau optique intégrant toutes les liaisons disponibles, avec une "couleur", c'est-à-dire une longueur d'onde dans le signal optique, distincte par couple émetteur/récepteur, chaque lame ne pouvant voir que les couleurs dont elle est réceptrice.

Mais une telle technologie ne peut pas être mise en oeuvre de façon simple, sans ajout d'équipements complexes et coûteux. En effet, ce système requiert un système optique spécifique en plus de la connectique matérielle habituelle pour réaliser l'anneau optique. Ce système optique spécifique doit notamment comprendre des aiguillages optiques ou *splitters* pour dupliquer et/ou détourner les données vers un récepteur spécifique, et des filtres optiques pour empêcher le flux de données de tourner indéfiniment dans cet anneau, car l'ensemble est passif et basé sur l'utilisation de différentes "couleurs" optiques.

Le US 2007/0233927 A1 décrit une topologie de carte de fond de panier de type *mesh incomplet.* Pour pallier le fait que la topologie n'est plus de type "N-vers-N" comme dans une topologie *full mesh,* certains noeuds du maillage servent de routeurs pour faire suivre les données au destinataire. Il devient certes possible de réduire le nombre de liaisons et de ports réseau utilisés, mais au prix d'une complexité supplémentaire en raison des contraintes de re-routage.

Le US 2005/0227505 A1 décrit un châssis de type ATCA, et plus particulièrement une topologie de carte de fond de panier de type *dual star extended,* censée être un bon compromis entre les deux topologies *dual star* et *dual-dual star* par la spécification ATCA.

Le WO 2005/006144 A2 décrit un processus de communication entre un maitre et des esclaves dans une topologie de type bus.

En tout état de cause, dans les topologies *dual star* ou *full mesh* et leurs variantes, le but recherché est la redondance, permettant de garantir la continuité du service. Mais cette redondance est obtenue en contrepartie d'un coût important : recours à des lames dédiées, ou bien topologie complexe et réduction du nombre de ports disponibles, selon le cas.

Le but de l'invention est de remédier à ces limitations, en proposant une nouvelle topologie de fond de panier, applicable notamment à des châssis de type ATCA, qui s'affranchisse des solutions standard tout en offrant le même degré de redondance qu'une architecture conventionnelle *dual star,* mais toutefois en n'utilisant que des lames productives et sans accroissement de la connectivité réseau nécessaire, qui sera limitée à deux ports réseau par lame.

La solution de l'invention réside, essentiellement, dans une architecture où toutes les lames sont ordonnées en un anneau, chaque lame étant reliée à la lame précédente et à la lame suivante dans l'anneau ainsi défini. Il devient ainsi possible de n'avoir que des lames productives, sans recourir à des lames réseau, donc de n'avoir qu'un seul type de matériel à gérer et avec une occupation optimale des *slots* de chaque châssis.

Par ailleurs, la redondance est maintenue : en effet, si une lame tombe en panne ou est retirée (par exemple au moment d'une opération d'échange), il suffira de rediriger le trafic réseau sera dans le sens inverse de l'anneau pour poursuivre la transmission des données entre les lames.

Enfin, en ce qui concerne la carte de fond de panier, on notera qu'au niveau physique la connectique matérielle utilisée sera la même que pour une architecture *dual star* (à savoir deux liaisons réseau) et sera donc parfaitement rétrocompatible avec ce dernier standard, le plus utilisé.

Il sera seulement nécessaire de modifier la configuration de gestion du réseau, par mise en oeuvre d'un logiciel spécifique sur la lame permettant d'assurer une fonction de "mise en cascade" (fonction simple et en elle-même classique) en lieu et place de la "mise en étoile" de la topologie *dual star.*

Plus précisément, l'invention propose un équipement de réseau du type châssis modulaire comportant une pluralité de N lames amovibles et une carte de fond de panier recevant les N lames. Chaque lame comprend une interface de couplage dotée d'une pluralité de ports de connexion à un canal de liaison réseau, et la carte de fond de panier comporte un routage de liaisons réseau apte à coupler entre elles les N lames.

De façon caractéristique de l'invention, les N lames sont ordonnées selon une séquence logique de chainage prédéfinie et sont couplées séquentiellement entre elles, chaque lame étant couplée i) par un premier de ses ports de connexion à la lame qui la précède dans la séquence et ii) par un second de ses ports de connexion à la lame qui la suit dans la séquence, via une liaison réseau unique configurée sur la carte de fond de panier. La connectique matérielle de la carte de fond de panier est celle d'une architecture *dual star* non modifiée, avec sur chaque lame lesdits deux ports de connexion pour deux liaisons réseau. Chacune des lames comporte des moyens de transfert de données, aptes à transférer en cascade des données destinées à une autre des N lames du premier port de connexion vers le second port de connexion, ou *vice versa,* et le châssis est dépourvu de lame(s) dédiée(s) à l'interconnexion des liaisons réseau entre les autres lames de l'équipement.

Les moyens de transfert de données peuvent notamment comprendre des moyens d'analyse de l'exécution d'un transfert de données d'une lame émettrice vers une lame réceptrice, et des moyens aptes à inverser le sens de circulation des données sur ladite liaison réseau unique sur détection d'une impossibilité ou d'une anomalie de ladite exécution du transfert de données.

Les caractéristiques matérielles des lames et de la carte de fond de panier sont avantageusement conformes à la spécification ATCA.

On va maintenant décrire un exemple de mise en oeuvre de l'invention, en référence aux dessins annexés où les mêmes références désignent d'une figure à l'autre des éléments identiques ou bien fonctionnellement semblables.
La Figure 1 est une vue schématique, de dessus, d'un châssis intégrant une série de lames montées sur une carte de fond de panier.
Les Figures 2a et 2b illustrent, respectivement, les topologies conventionnelles *dual star* et *full mesh.*
La Figure 3 illustre la topologie particulière selon la présente invention.
La Figure 4 est homologue de la Figure 3, pour montrer la manière dont la continuité de fonctionnement du réseau est assurée même en cas de défaillance de l'une des lames.

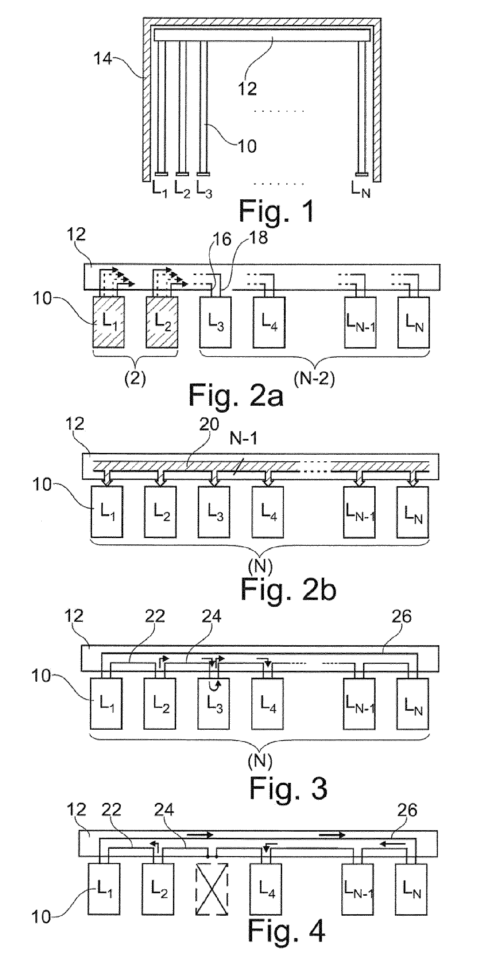

La Figure 1 représente schématiquement en vue de dessus la configuration d'un châssis, typiquement un châssis de type ATCA, comprenant une série de lames 10 enfichées chacune dans un emplacement correspondant d'une carte de fond de panier 12. La spécification ATCA prévoit ainsi de juxtaposer N = 14 ou N = 16 lames 10, désignées L₁, L₂, L₃... L_{N} sur les figures, sur une même carte de fond de panier 12 elle-même placée dans un châssis 14 de format ATCA.

La Figure 2a illustre la topologie conventionnelle *dual star,* la plus courante. Dans cette topologie, deux lames L₁ et L₂ sont des "lames réseau", dédiées à l'interconnexion des N-2 autres lames L₃, L₄... L_{N}, qui sont des "lames productives". Le routage effectué par la carte de fond de panier 12 ne nécessite que deux liaisons réseau 16, 18, une vers chacune des deux lames réseau L₁ et L₂. Le routage est identique pour les lames réseau L₁ et L₂, celles-ci n'étant au nombre de deux que par redondance, pour des raisons de sécurité et de continuité de service même en cas de défaillance d'une lame. En ce qui concerne les lames productives, L₃... L_{N}, il n'est nécessaire d'utiliser sur chacune de celles-ci que deux ports réseau pour l'interconnexion, les autres ports de la lame restant ainsi disponibles pour des fonctions productives.

La Figure 2b illustre une autre architecture possible prévue par la spécification ATCA, à savoir une architecture de type *full mesh.* Cette architecture ne met en oeuvre aucune lame réseau, ce qui permet d'occuper le châssis uniquement avec des lames productives L₁... L_{N}, par exemple seize lames productives pour une occupation maximale du châssis. Pour l'interconnexion entre lames, la carte de fond de panier 12 est configurée avec un routage à liaisons multiples 20 comprenant N-1 canaux permettant à chacune des N lames 10 d'être connectée directement (et non plus via une lame réseau comme dans l'architecture *dual star*) à chacune des N-1 autres lames du châssis. L'inconvénient de cette topologie, outre sa complexité de gestion du réseau (relation de type "N-vers-N"), est d'occuper sur chaque lame 10 N-1 ports de connexion, réduisant d'autant le nombre de ports disponibles pour une fonction productive.

La Figure 3 illustre la solution proposée par l'invention qui consiste à établir une nouvelle architecture où les N lames - qui sont toutes des lames productives - sont ordonnées selon une séquence logique de chainage et sont couplées séquentiellement entre elles, chaque lame productive étant reliée à la lame précédente et à la lame suivante (et seulement à ces deux lames). Par exemple, la lame L₂ est reliée à la lame L₁ par la liaison 22 et à la lame L₃ par la liaison 24, et de même pour toutes les autres lames, la dernière lame L_{N} étant reliée à la lame L_{N-1} qui la précède et à la lame L₁ qui la suit dans la boucle par la liaison retour 26.

Comme on peut le constater, cette solution cumule, sans leurs inconvénients, les avantages :
- de la topologie *dual star,* car elle n'utilise que deux ports de connexion par lame,
- et de la topologie *full mesh,* car toutes les lames sont des lames productives (il n'y a pas de lame réseau).

De plus, par rapport à une topologie *dual star,* la compatibilité matérielle de la connectique est conservée, avec sur chaque lame deux ports de connexion, pour deux liens réseau. Seule change la configuration du réseau, qui pourra être programmée par un simple module logiciel de *cas-cading* sur chaque lame, opérant le transfert en cascade d'un flux incident, arrivant sur un premier port de connexion de la lame, de données destinées à une autre des lames du châssis, en sortie vers un second port de connexion de cette même lame.

On notera que la redondance est parfaitement maintenue : si, comme illustré Figure 4, une lame est défaillante ou est retirée du châssis (par exemple la lame L₃ sur la Figure 4), cette situation sera détectée par le logiciel de gestion du réseau, qui redirigera alors le trafic réseau dans le sens inverse, s'il constate qu'il n'est pas possible que le flux de données incident atteigne la lame destinataire avec le sens initial de circulation des données. Ainsi, si l'on veut par exemple transférer des données de la lame L₂ vers la lame L₄, il ne sera plus possible de faire transiter ces données par la lame L₃ (comme sur la Figure 3). La lame L₂ détectera cette situation et commandera alors l'inversion du sens de circulation du trafic réseau de L₂ vers L₁, puis L_{N}, puis L_{N-1}... et ainsi de suite, de proche en proche, jusqu'à L₄.

Une topologie en anneau permet en effet d'envisager deux sens de circulation possible des données, garantissant de ce fait la redondance qui, dans une topologie *dual star,* était assurée par la présence de lames réseau dédoublées (L₁ et L₂ sur la Figure 2a).

## Revendications

1. Un équipement de réseau, du type châssis modulaire comportant une pluralité de N lames amovibles (10) et une carte de fond de panier (12) recevant les N lames,
chaque lame (10) comprenant une interface de couplage dotée d'une pluralité de ports de connexion à un canal de liaison réseau,
la carte de fond de panier (12) comportant un routage de liaisons réseau apte à coupler entre elles les N lames,
**caractérisé en ce que** :
- les N lames (L₁, L₂... L_{N}) sont ordonnées selon une séquence logique de chainage prédéfinie et sont couplées séquentiellement entre elles ;
- chaque lame est couplée i) par un premier de ses ports de connexion à la lame qui la précède dans la séquence et ii) par un second de ses ports de connexion à la lame qui la suit dans la séquence, via une liaison réseau unique (22, 24) configurée sur la carte de fond de panier,
- la connectique matérielle de la carte de fond de panier est celle d'une architecture *dual star* non modifiée, avec sur chaque lame lesdits deux ports de connexion pour deux liaisons réseau ;
- chacune des lames comporte des moyens de transfert de données, aptes à transférer en cascade des données destinées à une autre des N lames du premier port de connexion vers le second port de connexion, ou *vice versa* ; et
- le châssis est dépourvu de lame(s) dédiée(s) à l'interconnexion des liaisons réseau entre les autres lames de l'équipement.

2. L'équipement de la revendication 1, dans lequel lesdits moyens de transfert de données comprennent en outre des moyens d'analyse de l'exécution d'un transfert de données d'une lame émettrice vers une lame réceptrice, et des moyens aptes à inverser le sens de circulation des données sur ladite liaison réseau unique sur détection d'une impossibilité ou d'une anomalie de ladite exécution du transfert de données.

3. L'équipement de la revendication 1, dans lequel les caractéristiques matérielles des lames et de la carte de fond de panier sont conformes à la spécification ATCA.
